# EUROPEAN PATENT SPECIFICATION

(11) **EP 3 327 883 B1**
(45) Date of publication and mention of the grant of the patent: **09.09.2020**
(21) Application number: 15898882.4
(22) Date of filing: 17.07.2015
(51) Int. Cl.: H02M 1/32, H02H 7/08, H03K 17/22

(54) **SHUTOFF CONTROL METHOD AND POWER CONVERSION DEVICE USING SAME**
ABSCHALTSTEUERUNGSVERFAHREN UND ENERGIEUMWANDLUNGSVORRICHTUNG DAMIT
PROCÉDÉ DE COMMANDE D'ARRÊT ET DISPOSITIF DE CONVERSION DE COURANT L'UTILISANT

(43) Date of publication of application: 30.05.2018
(73) Proprietor: Hitachi Industrial Equipment Systems Co., Ltd., Tokyo 101-0022 (JP)
(72) Inventor: ARAO, Yusuke, Tokyo 101-0022 (JP); EJIMA, Shingo, Tokyo 101-0022 (JP)
(74) Representative: Strehl Schübel-Hopf & Partner
(86) International application number: PCT/JP2015/070612
(87) International publication number: WO 2017/013722

(56) References cited:
- JP-A- H08 153 440
- JP-A- H11 234 816
- JP-A- 2011 101 446
- JP-A- 2014 087 166
- JP-A- 2014 147 239
- JP-B1- 5 606 651
- US-A- 5 492 273
- US-A1- 2005 030 045
- US-A1- 2010 309 589
- US-A1- 2011 307 910

## Description

### TECHNICAL FIELD

The present invention relates to a shutoff control method of a device, and more particularly to, an interlock for achieving a safety function of a device.

### BACKGROUND ART

A background art of the present technical field is disclosed in JP 11-234816 A (Patent Document 1). In Patent Document 1, "a door switch 15 which is turned off only when a door is fully closed is connected to a shunt trip coil 12 of an embedded breaker 11, and if the door is opened during an operation, the door switch 15 is turned on to trip the embedded breaker 11. If a cancel switch 30 is connected to the door switch 15 in series, it is possible to cancel the action of the door switch 15 in accordance with opening/closing of the cancel switch 30. Further, when the door switch 25 which is turned on only when the door is fully closed is connected to an undervoltage trip coil 22 of an embedded breaker 21, and if the door is opened during an operation, the door switch 25 is turned off to trip the embedded breaker 21. If a cancel switch 40 is connected to the door switch 25 in parallel, it is possible to cancel the action of the door switch 25 in accordance with opening/closing of the cancel switch 40." is stated.

### CITATION LIST

### PATENT DOCUMENT

Patent Document 1: JP 11-234816 A

### SUMMARY OF THE INVENTION

### PROBLEMS TO BE SOLVED BY THE INVENTION

In Patent Document 1, a mechanism in which an electric door interlock circuit of a switchboard includes a door switch that detects whether or not a door is fully closed, a trip circuit that trips a power source switching device in accordance with a signal from the door switch in a state other than a state in which the door is fully closed, and a cancel switch that invalidates an operation of the door switch is stated.

In the mechanism of Patent Document 1, it is necessary to separately install the cancel switch for canceling an interlock, and it is necessary to perform a complicated work of pushing cancellation each time the door is closed although the door is normally opened or closed. Further, in the mechanism of Patent Document 1, an operation when a failure occurs in the interlock is not mentioned, a case in which the interlock circuit is doubly assembled is not taken into consideration, and a problem and a solution thereof are not mentioned.

US 2011/307910 A1 discloses a method for controlling a multi-output power supply device with the features in the preamble of present claim 1. Another conventional power supply device is described in US 2005/030045 A1.

It is an object of the present invention to provide a mechanism in which, when an abnormal manipulation is performed in interlock control, a safety interlock is performed, and a warning is given to a worker.

### SOLUTIONS TO PROBLEMS

In order to solve the above problem, for example, configurations set forth in claims are employed. The present application includes a plurality of constituent elements for solving the above-mentioned problem, and as an example, a shutoff control method of deciding a shutoff status of a device in accordance with transition statuses of two signals includes a first step of outputting a shutoff signal to the device when the two signals correspond to a predetermined shutoff status, a second step of causing both of the two signals to enter a predetermined shutoff cancellation status after both of the two signals enters the predetermined shutoff status, and a third step of cancelling the shutoff status of the device and activating the device without performing a reset process.

### EFFECTS OF THE INVENTION

According to the present invention, it is possible to provide a shutoff control method according to claim 1 and an electric power conversion device according to claim 10 using the method which are capable of performing an interlock and giving a warning at the time of abnormality without need to perform a complicated work when an interlock function is normally performed.

### BRIEF DESCRIPTION OF THE DRAWINGS

Fig. 1 is a system configuration diagram using an electric power conversion device according to a first embodiment.
Fig. 2 is a flowchart illustrating an overall operation of a diagnosing unit according to the first embodiment.
Fig. 3 is a detailed flowchart illustrating a shutoff signal input step in Fig. 2.
Fig. 4 is a continuation of the detailed flowchart illustrating the shutoff signal input step in Fig. 2.
Fig. 5 is a continuation of the detailed flowchart illustrating the shutoff signal input step in Fig. 2.
Fig. 6 is a detailed flowchart illustrating a cancellation operation step in Fig. 2.
Fig. 7 is a continuation of a detailed flowchart illustrating a cancellation operation step in Fig. 2.
Fig. 8 is a diagram illustrating a function setting screen in a manipulating unit that inputs various kinds of settings in the electric power conversion device according to the first embodiment.
Fig. 9 is a system configuration diagram using an electric power conversion device and a control device according to a second embodiment.

### MODE FOR CARRYING OUT THE INVENTION

Hereinafter, embodiments will be described with reference to the appended drawings.

### First embodiment

In the present embodiment, in electric power conversion device, an AC converting unit includes a shutoff unit that shuts off electric power to be applied to an AC motor, and an example of an interlock function related to shutoff control will be described. The interlock indicates holding a shutoff status to achieve a safety function of a device.

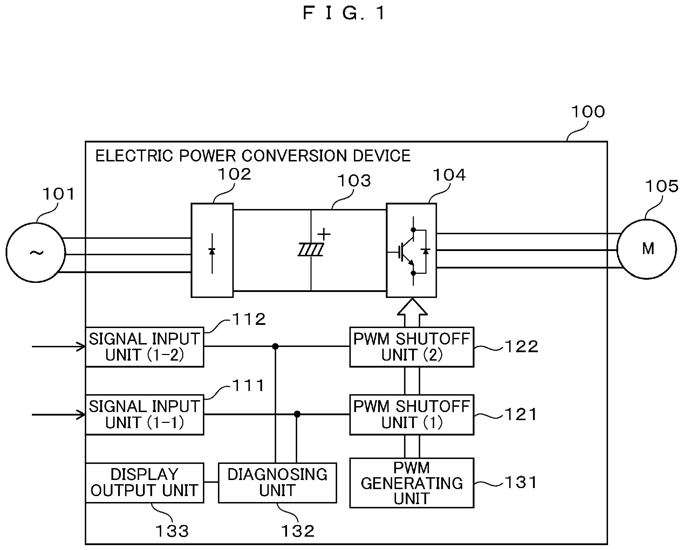

Fig. 1 is a system configuration diagram of an electric power conversion device 100, a three-phase AC power source 101, and an AC motor 105 according to the present embodiment. Referring to Fig. 1, the electric power conversion device 100 includes a DC converting unit 102, a DC smoothing unit 103, an AC converting unit 104, a signal input unit (1-1) 111, a signal input unit (1-2) 112, a PWM shutoff unit (1) 121, a PWM shutoff unit (2) 122, a PWM generating unit 131, a diagnosing unit 132, and a display output unit 133.

In Fig. 1, the three-phase AC power source 101 outputs, for example, a three-phase AC voltage supplied from an electric power company or an AC voltage supplied from a generator to the DC converting unit 102.

For example, the DC converting unit 102 is configured with a DC conversion circuit including a diode or a DC conversion circuit using an IGBT and a flywheel diode, and converts the AC voltage input from the three-phase AC power source 101 into a DC voltage and outputs the DC voltage to the DC smoothing unit 103. In Fig. 1, the DC converting unit including a diode is illustrated.

The DC smoothing unit 103 is a smoothing capacitor and smooths the DC voltage input from the DC converting unit 102 and outputs the DC voltage to the AC converting unit 104. For example, when an output of the generator is a DC voltage, the DC smoothing unit 103 may receive the DC voltage directly from the DC generator without intervention of the DC converting unit 102.

For example, the AC converting unit 104 is configured with an AC conversion circuit using an IGBT and a flywheel diode, and receives the DC voltage of the DC smoothing unit 103 and a PWM command of the PWM generating unit 131, converts the DC voltage into an AC voltage, and output the AC voltage to the AC motor 105.

The signal input unit (1-1) 111 and the signal input unit (1-2) 112 receive shutoff command signals from the outside and output the shutoff commands to the PWM shutoff unit (1) and the PWM shutoff unit (2) corresponding thereto. The signal input unit (1-1) 111 and the signal input unit (1-2) 112 need not be input units having the same mechanism and may be general I/O units or ports for performing communication as long as they transfer signals to the PWM shutoff units.

The PWM shutoff unit (1) 121 and the PWM shutoff unit (2) 122 receive the shutoff commands of the signal input unit (1-1) 111, the signal input unit (1-2) 112, and the diagnosing unit 132 connected thereto, determine whether the PWM signals to be output from the PWM generating unit 131 to the AC converting unit 104 are passed or shut off in the respective systems, and perform the PWM shutoff. The PWM shutoff unit (1) 121 and the PWM shutoff unit (2) 122 need not be shutoff units having the same mechanism as long as it is possible to cause the AC converting unit 104 not to supply electric power for rotating the AC motor 105. For example, the PWM shutoff unit (1) 121 may shut off some PWM signals, and the PWM shutoff unit (2) 122 may shut off the remaining PWM signals.

The PWM generating unit 131 generates a PWM pulse which is a PWM signal for driving the AC motor 105 and gives a PWM command to the AC converting unit 104 through the PWM shutoff unit (1) 121 and the PWM shutoff unit (2) 122.

The diagnosing unit 132 determines and diagnoses whether or not the signal input unit (1-1) 111 and the signal input unit (1-2) 112 are in a predetermined PWM shutoff status, and transfer a shutoff retention command to the PWM shutoff unit (1) 121 and the PWM shutoff unit (2) 122 in accordance with the status. The diagnosing unit 132 causes the PWM shutoff to continue and outputs a diagnosis result to inform the display output unit 133 of a status. For example, the diagnosing unit 132 performs a process within a fixed period task and uses communication data or a signal level taken as High/Low. A malfunction caused by a noise may be prevented by acquiring the signal level taken as High/Low and determining the signal level.

The display output unit 133 receives the diagnosis result of the diagnosing unit 132 and displays an indication corresponding to the diagnosis result or outputs an output signal corresponding to the diagnosis result to the outside. The display output unit 133 may be configured with an external PC or another device.

Although not illustrated, the electric power conversion device 100 may include a manipulating unit that inputs various kinds of settings, and the display output unit 133 may be a touch input type display panel and double as the manipulating unit.

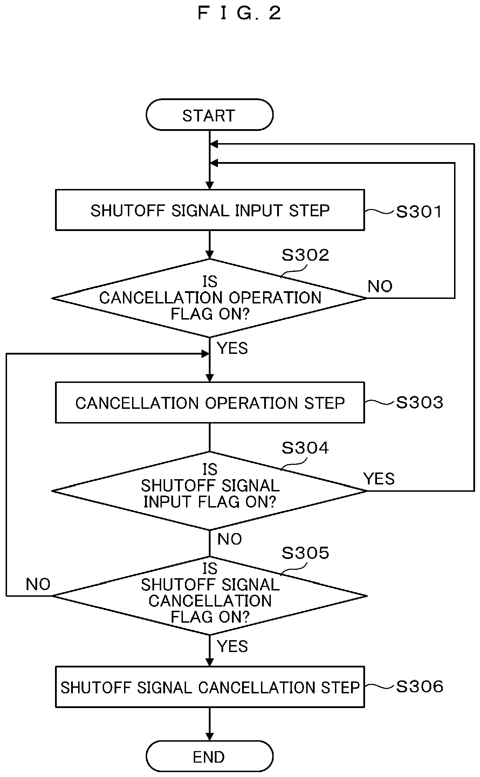

Fig. 2 is a flowchart illustrating an overall operation of the diagnosing unit 132 according to the present embodiment. Referring to Fig. 2, the diagnosing unit 132 executes a shutoff signal input step for inputting two shutoff signals of signal input unit (1-1) 111 and signal input unit (1-2) 112 as a first step (S301). The diagnosing unit 132 monitors the shutoff status of the two shutoff signals. In step (S302), a cancellation operation flag indicating that both of the two shutoff signals are in the shutoff status is checked, it is checked that both of the two shutoff signals are in the shutoff status (the cancellation operation flag is ON), and then the process proceeds to a cancellation operation step which is a second step (S303).

If both of both of the two shutoff signals are not in the shutoff status, the diagnosing unit 132 commands the PWM shutoff unit (1) 121 and the PWM shutoff unit (2) 122 to hold the shutoff status without proceeding to the second step.

In step (S304), it is checked that a shutoff signal input flag for returning to the shutoff signal input step (S301) to be described later is not ON, and the process proceeds to a next step (S305).

In step (S305), it is checked that the shutoff signal cancellation flag for proceeding to a shutoff signal cancellation step (S306) to be described later is ON, and the process proceeds to a next step (S306).

Step (S306) is a shutoff signal cancellation step which is a third step, and the diagnosing unit 132 cancels the shutoff commands to the PWM shutoff unit (1) 121 and the PWM shutoff unit (2) 122 at a timing at which both of the signal input unit (1-1) 111 and the signal input unit (1-2) 112 enter the cancellation status without need to perform an external reset operation.

As described above, the processing flow of Fig. 2 is a shutoff control method of deciding a shutoff status of a device in accordance with transition statuses of two shutoff signals and includes a first step of outputting a shutoff signal to the device when the two shutoff signals correspond to a predetermined shutoff status, a second step of causing both of the two shutoff signals to enter a predetermined shutoff cancellation status after both of the two shutoff signals enters the predetermined shutoff status, and a third step of cancelling the shutoff status of the device and activating the device without performing a reset process.

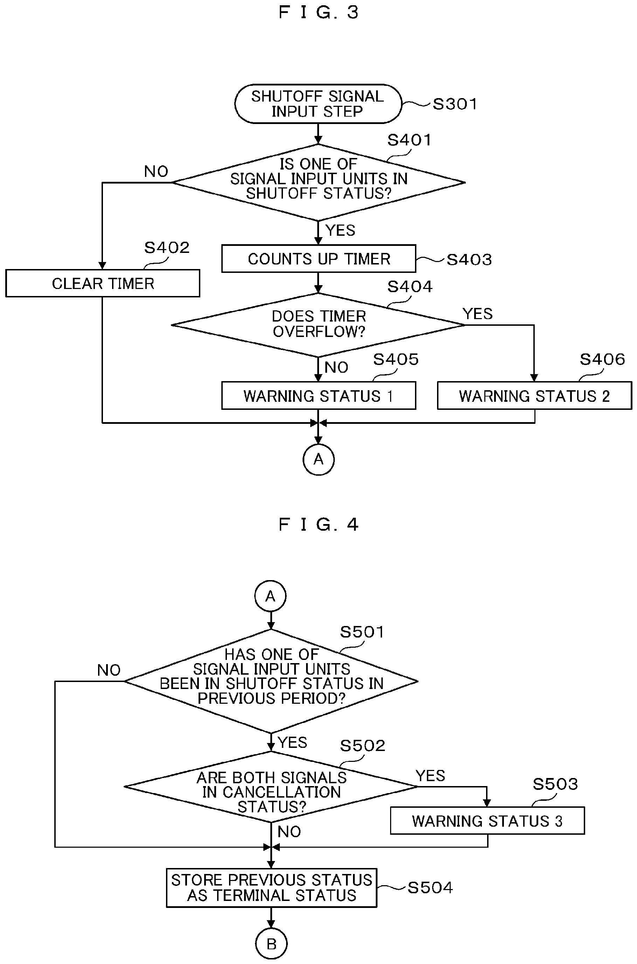

Fig. 3 is a detailed flowchart illustrating the shutoff signal input step (S301) in Fig. 2. Specifically, Fig. 3 is a flowchart mainly illustrating an operation in which any one of the signal input unit (1-1) 111 and the signal input unit (1-2) 112 is in a shutoff input status in the shutoff signal input step (S301).

In Fig. 3, the diagnosing unit 132 determines whether or not one of the signal input unit (1-1) 111 and the signal input unit (1-2) 112 is in the shutoff status (S401). When both of two inputs of the input signal units are in the shutoff status or the cancellation status, a counter value obtained by counting an elapsed time in which one of the signal input unit (1-1) 111 and the signal input unit (1-2) 112 is in the shutoff status is cleared (S402).

When any one input is in the shutoff status as a predetermined status, the diagnosing unit 132 counts the elapsed time in which one input is in the shutoff status (S403) and determines whether or not the count overflows with respect to a predetermined value determined to be an input abnormality (S404).

If the count does not overflow, the diagnosing unit 132 determines that the shutoff signal is input and outputs a warning status 1 to the display output unit 133 in accordance with the shutoff status of the signal input unit (1-1) 111 and the signal input unit (1-2) 112 (404). For example, when only the signal input unit (1-1) 111 is in the shutoff status, the display output unit 133 determines that there is an abnormality in the signal input unit (1-2) 112 and displays "Status 1-2." When only the signal input unit (1-2) 112 is in the shutoff status, the display output unit 133 determines that there is an abnormality in the signal input unit (1-1) 111 and displays "Status 1-1." Further, the display output unit 133 may selectively set the presence or absence of display in advance, select whether or not the display of the warning status 1 is output to the display output unit 133, or display "Status 1" to indicate the status of one input.

If the count overflows, it is determined that the shutoff status of one of the inputs is not simply delayed, but there is an abnormality, and a warning status 2 is output to the display output unit 133 (S406). For example, when only the signal input unit (1-1) 111 is in the shutoff status, the display output unit 133 determines that there is an abnormality in the signal input unit (1-2) 112 and displays "Status 2-2." When only the signal input unit (1-2) 112 is in the shutoff status, it is determined that there is an abnormality in the signal input unit (1-1) 111, and "Status 2-1" is displayed. Further, the display output unit 133 may selectively set the presence or absence of display in advance, select whether or not the display of the warning status 2 is output to the display output unit 133, or display "Status 2 "to indicate the status of one input.

Further, for example, when both of the signals of the signal input unit (1-1) 111 and signal of the signal input unit (1-2) 112 are in the cancellation status at the time of the warning status 1, the diagnosing unit 132 may determine that the cancellation have been performed within a normal time and cancel the shutoff continuation.

As described above, in the processing flow of Fig. 3, when a predetermined period of time or more elapses in a state in which only one of the two shutoff signals is in a predetermined shutoff status, and the other is in a predetermined shutoff cancellation status, it is determined to be a predetermined abnormal status, and warning information is output to the device.

Further, a plurality of predetermined periods of time may be set, and a plurality of warning signals may be output to the device in accordance with the elapsed time each time the elapsed time increase.

Fig. 4 is a continuation of Fig. 3 and is a flowchart mainly illustrating an operation in a case in which both the signals enter the cancellation status before the overflow occurs in 404 of Fig. 3 after any one of the signal input unit (1-1) 111 and the signal input unit (1-2) 112 enters the shutoff input status in the shutoff signal input step (S301).

In Fig. 4, the diagnosing unit 132 performs a process, for example, in accordance with a periodic task, determines whether or not any one of the signal input unit (1-1) 111 and the signal input unit (1-2) 112 has been in the shutoff status in a previous period (S501), determines whether or not the both signals are currently in the cancellation status when any one of the signal input unit (1-1) 111 and the signal input unit (1-2) 112 has been in the shutoff status in the previous period (S502), shuts off any one of the both signals in the cancellation status, that is, any one of the two input signals, determines that there is an abnormality in the other signal when the shutoff cancellation is performed later, and outputs a warning status 3 to the display output unit 133. For example, when only the signal input unit (1-1) 111 enters the cancellation status after the shutoff status, the display output unit 133 determines that there is an abnormality in the signal input unit (1-2) 112 and displays "Status 3-2." Further, when only signal input unit (1-2) 112 enters the cancellation status after the shutoff status, the display output unit 133 determines that there is an abnormality in the signal input unit (1-1) 111 and displays "Status 3-1." Further, the display output unit 133 may selectively set the presence or absence of display in advance, select whether or not the display of the warning status 3 is output to the display output unit 133, or display "Status 3" to indicate the status of one input.

When it enters the warning status 3, the diagnosing unit 132 commands the PWM shutoff unit (1) 121 and the PWM shutoff unit (2) 122 to hold the shutoff status although the signal input unit (1-1) 111 and the signal input unit (1-2) 112 are in the cancellation status. When it enters the warning status 3, the diagnosing unit 132 may transfer the shutoff command to both the signal input unit (1-1) 111 and the signal input unit (1-2) 112.

As a modified example of Fig. 4, for example, when both of the signals of the signal input unit (1-1) 111 and signal input unit (1-2) 112 enter the cancellation status in the status of the warning status 1, the diagnosing unit 132 may determine that the cancellation have been performed within a normal time, cancel the shutoff continuation, and perform a process so that it transitions to the warning status 3 only in the status of the warning status 2.

As described above, in the processing flow of Fig. 4, when both of the two shutoff signals transition from a state in which one of the two shutoff signals is in a predetermined shutoff status, and the other is in a predetermined shutoff cancellation status to a predetermined shutoff cancellation status, it is determined to be a predetermined abnormal status, and the warning information is output to the device.

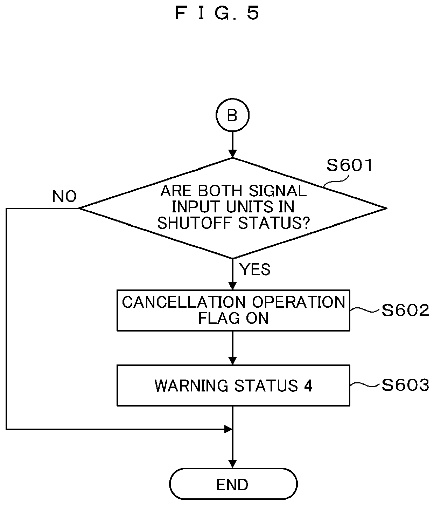

Fig. 5 is a continuation of Fig. 4 and is a flowchart mainly illustrating an operation when the process proceeds from the shutoff signal input step to the cancellation operation step.

In Fig. 5, the diagnosing unit 132 determines whether both of the signal input unit (1-1) 111 and the signal input unit (1-2) 112 are in the shutoff status (S601), and if both of the signal input unit (1-1) 111 and the signal input unit (1-2) 112 are in the shutoff status, the cancellation operation flag indicating that both the signal input units enter the shutoff status is set to ON (S602).

Then, in step (S603), when both of the signals are in the shutoff status, the diagnosing unit 132 outputs a warning status 4 indicating that both of the signals are in the shutoff status to the display output unit 133. For example, the display output unit 133 displays "Status 4" when both of the signals enter the shutoff status. Further, the display output unit 133 may selectively set the presence or absence of display beforehand and select whether or not the display of the warning status 4 is output to the display output unit 133.

As described above, in the processing flow of Fig. 5, when the both of the two shutoff signals are in a predetermined shutoff status while transition from the first step to the second step is being performed, the warning information is output to the device.

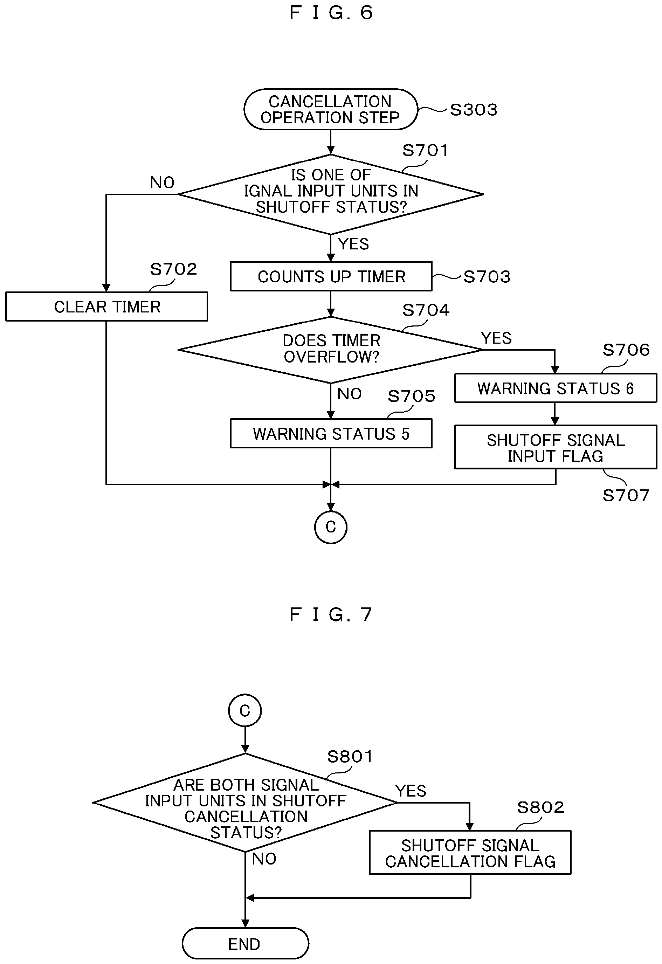

Fig. 6 is a detailed flowchart illustrating the shutoff cancellation operation step (S303) in Fig. 2. Specifically, Fig. 6 is a flowchart mainly illustrating an operation in which any one of the signal input unit (1-1) 111 and the signal input unit (1-2) 112 is in the shutoff input status in the shutoff cancellation operation step (S303).

Referring to Fig. 6, the diagnosing unit 132 determines whether one of the signal input unit (1-1) 111 and the signal input unit (1-2) 112 is in the shutoff status (S701). When both inputs of the input signal units are in the shutoff status or in the cancellation status, the counter value obtained by counting the elapsed time in which one side input is in the shutoff status is cleared (S702).

When either one input is in the shutoff status, in step (S703), the elapsed time in which one input is in the shutoff status is counted, and it is determined whether or not the count overflows with respect to a predetermined value determined to be an input abnormality (S704). If the count does not overflow, the diagnosing unit 132 outputs a warning status 5 to the display output unit 133 in accordance with the shutoff status of the signal input unit (1-1) 111 and the signal input unit (1-2) 112 (S705). This warning is to warn content thereof as an abnormality because transition from the state in which both are in the shutoff status to the state in which only one is in the shutoff status, that is, only one is in the cancellation status is performed. For example, when only the signal input unit (1-1) 111 is in the shutoff status, the display output unit 133 determines that there is an abnormality in the signal input unit (1-2) 112 and displays "Status 5-2." When only the signal input unit (1-2) 112 is in the shutoff status, the display output unit 133 determines that there is an abnormality in the signal input unit (1-1) 111 and it displays "Status 5-1." Further, the display output unit 133 may selectively set the presence or absence of display in advance, select whether or not the display of the warning status 1 is output to the display output unit 133, or display "Status 5" to indicate the status of one input.

If the count overflows, it is determined that there is an abnormality, and a warning status 6 is output to the display output unit 133 (S706). This warning is to warn content thereof as an abnormality because a period in which transition from the state in which both are in the shutoff status to the state in which only one is in the shutoff status, that is, only one is in the cancellation status is performed continues for a predetermined period of time. For example, when only the signal input unit (1-1) 111 is in the shutoff status, the display output unit 133 determines that there is an abnormality in the signal input unit (1-2) 112 and displays "Status 6-2." When only the signal input unit (1-2) 112 is in the shutoff status, it is determined that there is an abnormality in the signal input unit (1-1) 111 and displays "Status 6-1." Further, the display output unit 133 may selectively set the presence or absence of display in advance, select whether or not the display of the warning status 6 is output to the display output unit 133, or display "Status 6" to indicate the status of one input. When it enters the warning status 6, the diagnosing unit 132 may transition to the warning status 2 which is the same signal status.

When it enters the warning status 6, the diagnosing unit 132 returns to the shutoff signal input step, and in order to cancel the shutoff status, it is necessary for both of the signals to be in the cancellation status once. Therefore, in step (S707), the shutoff signal input flag for returning to the shutoff signal input step (S301) is set to ON.

As described above, in the processing flow of Fig. 6, when a predetermined period of time elapses in a state in which the transition from the state in which the both of the two shutoff signals are in a predetermined shutoff signal to the state in which any one of the two shutoff signals is in a predetermined shutoff cancellation status, it is determined to be a predetermined abnormal status, and the warning information is output to the device.

Further, a plurality of predetermined periods of time may be set, and a plurality of warning signals may be output to the device each time the elapsed time increase.

Further, the shutoff signal input flag is set to ON so that the shutoff status continues if the operation of causing both of the two shutoff signals to enter a predetermined shutoff cancellation status after causing both of the two shutoff signals to enter a predetermined shutoff status which is the second step is not performed again when a predetermined time elapses.

Fig. 7 is a continuation of Fig. 6, and in the shutoff cancellation operation step (S303), it is determined whether or not both of the signal input unit (1-1) 111 and the signal input unit (1-2) 112 are in the shutoff cancellation status (S801), and when both of the signal input unit (1-1) 111 and the signal input unit (1-2) 112 are in the cancellation status, the shutoff signal cancellation flag for proceeding to a next shutoff signal cancellation step (S306) is set to ON (S802).

As described above, in the processing flow of Fig. 7, when the two shutoff signals transition from a predetermined shutoff status to a predetermined shutoff cancellation status, activation of the device is permitted at a timing at which the two shutoff signals enter the cancellation status, that is, using a signal entering the shutoff cancellation status later out of the two shutoff signals as a trigger.

Further, as described above, in the processing flow of Figs. 6 and 7, when both of the two shutoff signals are in a predetermined shutoff status and enter a predetermined shutoff cancellation status within a predetermined period of time, the process proceeds to the third step.

In the shutoff signal cancellation step (S306) illustrated in Fig. 2, the shutoff commands to the PWM shutoff unit (1) 121 and the PWM shutoff unit (2) 122 are canceled at a timing at which both of the signal input unit (1-1) 111 and the signal input unit (1-2) 112 enter the cancellation status without need to perform an external reset operation, but when any one of the warning statuses is output, the shutoff command is transferred to at least either or both of the PWM shutoff unit (1) 121 and the PWM shutoff unit (2) 122.

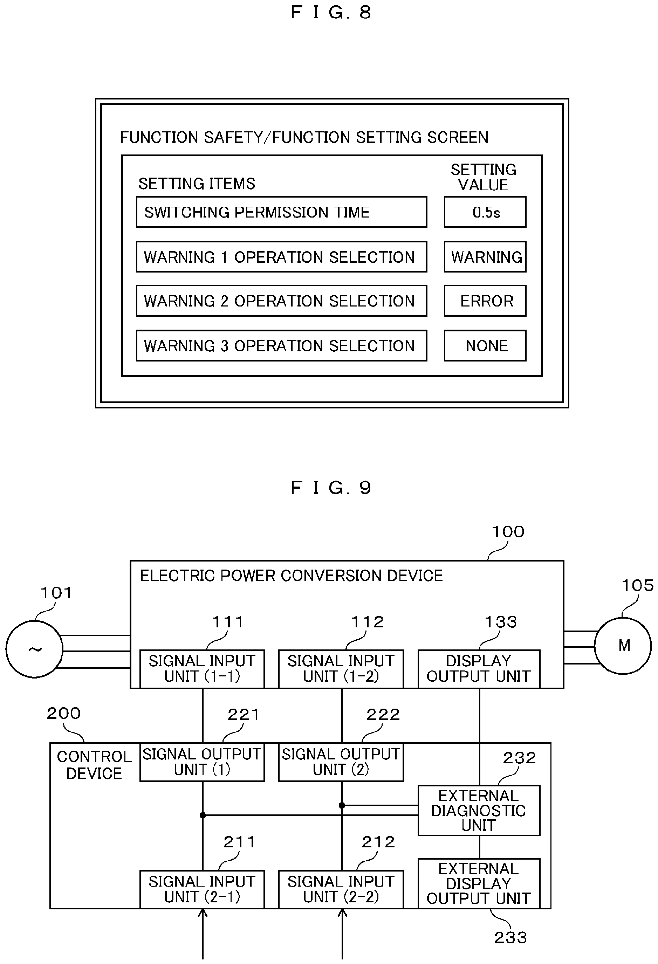

Fig. 8 is a diagram illustrating a function setting screen in the manipulating unit that inputs various kinds of settings in the electric power conversion device according to the present embodiment. For example, the manipulating unit is a touch input type display panel and may perform an input setting. In Fig. 8, in the present embodiment, a setting item input screen and a setting value input screen thereof are illustrated as function setting screens related to function safety. As the setting items, there are a switching permission time which is a time setting value until an elapsed time in which one input is in the shutoff status is determined to overflow as described with reference to Figs. 3 and 6 and warning operation selection of setting operation selection of the warning statuses 1 to 6 described with reference to Figs. 3 and 6. For example, as illustrated in Fig. 8, in the case of the switching permission time, a setting value is set to 0.5 seconds. Further, in the warning operation selection, setting of "warning" indicates selection in which resetting is unnecessary, and it is canceled when a condition of a warning is canceled, setting of "error" indicates selection in which transition to a status necessary for resetting is performed, and setting of "none" indicates that transition is performed without displaying a warning status. The inputs may be selected in a pull-down manner. Further, the inputs are set by the user but may be set by default in advance.

Accordingly, it is possible to provide a shutoff control method and an electric power conversion device using the same which are capable of performing an interlock and giving a warning at the time of abnormality without need to perform a complicated work when two types of interlock functions are normally performed.

### Second embodiment

In the present embodiment, an example of a control device connected to an electric power conversion device will be described. The present embodiment is a modified example of the first embodiment, parts common to the first embodiment are denoted by the same reference numerals, and different parts will be described in detail.

In a configuration of the present embodiment, a control device 200 is connected to the electric power conversion device 100 of Fig. 1 described in the first embodiment, and an operation of the display output unit 133 is different from that of the first embodiment.

Fig. 9 is a system configuration diagram of an electric power conversion device 100, a control device 200, and an AC motor 105 according to the present embodiment. Referring to Fig. 9, the control device 200 includes a signal input unit (2-1) 211, a signal input unit (2-2) 212, a signal output unit (1) 221, a signal output unit (2) 222, an external diagnosing unit 232, and external display output unit 233.

The signal input unit (2-1) 211 and the signal input unit (2-2) 212 receive the shutoff command signals from the outside and output the shutoff commands to the signal output unit (1) 221 and the signal output unit (2) 222 corresponding thereto. The signal input unit (2-1) 211 and the signal input unit (2-2) 212 need not be input units having the same mechanism and may be general I/O units or ports for performing communication as long as they transfer signals to the PWM shutoff units.

The signal output unit (1) 221 and the signal output unit (2) 222 receive the shutoff commands from the connected signal input unit (2-1) 211, the signal input unit (2-2) 212, and the external diagnosing unit 232 connected thereto, and output the shutoff commands to the signal input unit (1-1) 111 and the signal input unit (1-2) 112 of the electric power conversion device 100 connected thereto.

The external diagnosing unit 232 determines whether the signal input unit (2-1) 211 and the signal input unit (2-2) 212 are in a predetermined shutoff status, and outputs a shutoff retention command to the signal output unit (1) 221 and the signal output unit (2) 222 in accordance with the status. The external diagnosing unit 232 causes the shutoff command to continue and outputs a diagnosis result for informing the display output unit 133 and the external display output unit 233 of the status. For example, the external diagnosing unit 232 performs a process within a fixed period task and uses communication data or a signal level taken as High/Low. A malfunction caused by a noise may be prevented by acquiring the signal level taken as High/Low and determining the signal level.

The external display output unit 233 receives the diagnosis result of the external diagnosing unit 232 and displays an indication corresponding to the diagnosis result or outputs an output signal corresponding to the diagnosis result to the outside.

In a case in which the display output unit 133 is connected to the external diagnosing unit 232, the display output unit 133 gives a priority to the diagnosis result of the external diagnosing unit 232 over the diagnosis result of the diagnosing unit 132 of the first embodiment, and displays an indication corresponding to the diagnosis result or outputs an output signal corresponding to the diagnosis result to the outside. Alternatively, the display output unit 133 may simultaneously perform the outputs to the external diagnosing unit 232 and the diagnosing unit 132.

An input/output destination of the external diagnosing unit 232 is different from that of the diagnosing unit 132 of the first embodiment, but the external diagnosing unit 232 determines operations of two input signals through an operation similar to that of the diagnosing unit 132, and thus detailed description is omitted.

Further, for example, as a modified example of the second embodiment, the intention of the present invention does not change even if the diagnosing unit 132 in Fig. 1 is eliminated, and the external diagnosing unit 232 is connected.

The diagnosing unit 132 and the external diagnosing unit 232 of the first and second embodiments may continuously perform the operations of the flowchart illustrated in Figs. 3, 4, and 5 or may selectively perform the operations of the flowchart illustrated in Figs. 3 and 4 in the first step. Further, the diagnosing unit 132 and the external diagnosing unit 232 may selectively perform the operation of the flowchart illustrated in Fig. 6 in the second step.

Further, even when there are three or more input units of the first embodiment and the second embodiment, it is possible to similarly perform an operation of deciding the shutoff status by deciding a signal level to enter the shutoff status in advance.

The present invention is not limited to the above-described embodiments and includes various modified examples. For example, the above embodiments have been described to facilitate understanding of the present invention, and the present invention is not limited to a configuration necessarily including all components described above. A component of a certain embodiment may be replaced with a component of another embodiment, or a configuration of another embodiment may be added to a configuration of a certain embodiment. Further, some of the components of each embodiment can be added, deleted, or replaced with other components of another embodiment, within the scope of the appended claims.

Furthermore, some or all of components, functions, processing units, processing devices, or the like described above may be implemented by hardware, for example, may be designed by an integrated circuit. Further, components, functions, and the like described above may be implemented by software by interpreting and executing a program for implementing the functions through a processor. Information such as a program, a table, a file, or the like of implementing each function may be stored in a recording device such as a memory, a hard disk, or a solid state drive (SSD) or a recording medium such as an IC card, an SD card, or a DVD.

Furthermore, in the above-described embodiment, a control line or an information line are illustrated since they are necessary for description, and all control lines or information lines necessary in a product are not necessarily illustrated. Practically, almost all the components may be connected to one another.

### REFERENCE SIGNS LIST

- 100: electric power conversion device
- 101: three-phase AC power source
- 102: DC converting unit
- 103: DC smoothing unit
- 104: AC converting unit
- 105: AC motor
- 111: signal input unit (1-1)
- 112: signal input unit (1-2)
- 121: PWM shutoff unit (1)
- 122: PWM shutoff unit (2)
- 131: PWM generating unit
- 132: diagnosing unit
- 133: display output unit
- 200: control device
- 211: signal input unit (2-1)
- 212: signal input unit (2-2)
- 221: signal output unit (1)
- 222: signal output unit (2)
- 232: external diagnosing unit
- 233: external display output unit

## Claims

1. A shutoff control method of deciding a shutoff status of an electric power conversion device (100) that comprises a DC/AC converter (104) receiving a PWM command from a PWM generating unit (131) in accordance with transition statuses of two signals received from an outside, comprising:
a first step (S301) of outputting two PWM shutoff commands to PWM shutoff units (121, 122) within the electric power conversion device (100) when the two signals correspond to a predetermined PWM shutoff status;
a second step (S303) of causing both of the two signals to enter a predetermined shutoff cancellation status after both of the two signals enter the predetermined PWM shutoff status; and
a third step (S306) of cancelling the shutoff status of the electric power conversion device (100) and activating the electric power conversion device (100) without performing a reset process,
**characterised in that**, in the third step (S306), when the two signals transition from the predetermined PWM shutoff status to the predetermined shutoff cancellation status, activation of the electric power conversion device (100) is permitted using as a trigger a signal out of the two signals that enters the predetermined shutoff cancellation status later.

2. The shutoff control method according to claim 1, wherein, in the first step (S301), when a predetermined period of time or more elapses in a state in which only one of the two signals is in the predetermined PWM shutoff status, and the other is in the predetermined shutoff cancelation status, it is determined to be a predetermined abnormal status, and a warning information is output to the device.

3. The shutoff control method according to claim 2, wherein, in the first step (S301), a plurality of predetermined periods of time are set, and a plurality of warning signals are output to the device in accordance with the elapsed time each time the elapsed time increases.

4. The shutoff control method according to claim 1, wherein, in the first step (S301), when transition from a state in which one of the two signals is in the predetermined PWM shutoff status, and the other is in the predetermined shutoff cancellation status to a state in which both of the two signals are in the predetermined shutoff cancellation status is performed, it is determined to be a predetermined abnormal status, and a warning information is output to the device.

5. The shutoff control method according to claim 1, wherein a warning information is output to the device when both of the two signals are in the predetermined PWM shutoff statuses while transition from the first step (S301) to the second step (S303) is being performed.

6. The shutoff control method according to claim 1, wherein, when both of the two signals are in the predetermined PWM shutoff status and enter the predetermined shutoff cancellation status within a predetermined period of time, transition from the second step (S303) to the third step (S306) is performed.

7. The shutoff control method according to claim 1, wherein, in the second step (S303), when a predetermined period of time elapses in a state in which transition from a state in which both of the two signals are in the predetermined PWM shutoff status to a state in which any one of the two signals is in the predetermined shutoff cancellation status is performed, it is determined to be a predetermined abnormal status, and warning information is output to the device.

8. The shutoff control method according to claim 7, wherein, in the second step (S303), a plurality of predetermined periods of time are set, and a plurality of warning signals are output to the device each time the elapsed time increases.

9. The shutoff control method according to claim 7, wherein, in the second step (S303), the shutoff status is caused to continue if an operation of causing both of the two signals to enter a predetermined shutoff cancellation status after causing both of the two signals to enter the predetermined PWM shutoff status which is the second step (S303) is not performed again when a predetermined time elapses.

10. An electric power conversion device (100), comprising:
a DC converting unit (102) that is adapted to convert an alternating current (AC) voltage of an AC power source into a direct current (DC) voltage;
a DC smoothing unit (103) that is adapted to smooth the DC voltage;
a PWM generating unit (131) that is adapted to generate a PWM signal;
an AC converting unit (104) that is adapted to convert the smoothed DC voltage into an AC voltage using the PWM signal and output the AC voltage;
first and second signal input units (111, 112) each of which is adapted to receive a shutoff command signal from an outside;
first and second PWM shutoff units (121, 122) each of which is adapted to pass or shut off the PWM signal to be output from the PWM generating unit (131) to the AC converting unit (104) in respective systems; and
a diagnosing unit (132) that is adapted to diagnose statuses of two shutoff command signals from the first and second signal input units (111, 112) and output a shutoff command to the first and second PWM shutoff units (121, 122),
wherein, when the two shutoff command signals correspond to a predetermined PWM shutoff status, the diagnosing unit (132) is adapted to output a shutoff signal to the first and second PWM shutoff units (121, 122), cause both of the two shutoff command signals to enter the predetermined shutoff cancellation status after both of the statuses of the two shutoff command signals enter the predetermined PWM shutoff status, cancel the shutoff status of the first and second PWM shutoff units (121, 122), and activate the first and second PWM shutoff units (121, 122) without performing a reset process, and
wherein, when the two shutoff command signals transition from the predetermined PWM shutoff status to the predetermined shutoff cancellation status, the diagnosing unit (132) is adapted to permit activation of the device using as a trigger a signal out of the two signals that enters the predetermined shutoff cancellation status later.

## Patentansprüche

1. Abschaltsteuerverfahren zum Entscheiden eines Abschaltzustands einer elektrischen Leistungswandlungsvorrichtung (100), die einen DC/AC-Wandler (104) aufweist, der einen PWM-Befehl von einer PWM-Erzeugungseinheit (131) gemäß Übergangszuständen von zwei Signalen empfängt, die von außerhalb empfangen werden, umfassend:
einen ersten Schritt (S301), in dem zwei PWM-Abschaltbefehle an PWM-Abschalteinheiten (121, 122) innerhalb der elektrischen Leistungswandlungsvorrichtung (100) ausgegeben werden, wenn die beiden Signale einem vorbestimmten PWM-Abschaltzustand entsprechen;
einen zweiten Schritt (S303), in dem bewirkt wird, dass beide der beiden Signale in einen vorbestimmten Abschaltaufhebungszustand eintreten, nachdem beide der beiden Signale in den vorbestimmten PWM-Abschaltzustand eingetreten sind; und
einen dritten Schritt (S306), in dem der Abschaltzustand der elektrischen Leistungswandlungsvorrichtung (100) aufgehoben und die elektrische Leistungswandlungsvorrichtung (100) aktiviert wird, ohne einen Rücksetzvorgang durchzuführen,
**dadurch gekennzeichnet, dass** in dem dritten Schritt (S306), wenn die beiden Signale von dem vorbestimmten PWM-Abschaltzustand in den vorbestimmten Abschaltaufhebungszustand übergehen, die Aktivierung der elektrischen Leistungswandlungsvorrichtung (100) unter Verwendung eines Signals aus den beiden Signalen, das später in den vorbestimmten Abschaltaufhebungszustand eintritt, als Trigger zugelassen wird.

2. Abschaltsteuerverfahren nach Anspruch 1, wobei in dem ersten Schritt (S301), wenn mindestens eine vorbestimmte Zeitspanne in einem Zustand verstreicht, in dem nur eines der beiden Signale in dem vorbestimmten PWM-Abschaltzustand und das andere in dem vorbestimmten Abschaltaufhebungszustand ist, bestimmt wird, dass es sich um einen vorbestimmten abnormen Zustand handelt, und eine Warninformation an die Vorrichtung ausgegeben wird.

3. Abschaltsteuerverfahren nach Anspruch 2, wobei in dem ersten Schritt (S301) mehrere vorbestimmte Zeitspannen eingestellt werden und mehrere Warnsignale gemäß der verstrichenen Zeit jedes Mal, wenn die verstrichene Zeit zunimmt, an die Vorrichtung ausgegeben werden.

4. Abschaltsteuerverfahren nach Anspruch 1, wobei in dem ersten Schritt (S301), wenn der Übergang von einem Zustand, in dem sich eines der beiden Signale in dem vorbestimmten PWM-Abschaltzustand und das andere in dem vorbestimmten Abschaltaufhebungszustand befindet, in einen Zustand, in dem sich beide der beiden Signale in dem vorbestimmten Abschaltaufhebungszustand befinden, durchgeführt wird, bestimmt wird, dass es sich um einen vorbestimmten abnormen Zustand handelt, und eine Warninformation an die Vorrichtung ausgegeben wird.

5. Abschaltsteuerverfahren nach Anspruch 1, wobei eine Warninformation an die Vorrichtung ausgegeben wird, wenn sich beide der beiden Signale in den vorbestimmten PWM-Abschaltzuständen befinden, während der Übergang von dem ersten Schritt (S301) zu dem zweiten Schritt (S303) durchgeführt wird.

6. Abschaltsteuerverfahren nach Anspruch 1, wobei, wenn sich beide der beiden Signale in dem vorbestimmten PWM-Abschaltzustand befinden und innerhalb einer vorbestimmten Zeitspanne in den vorbestimmten Abschaltaufhebungszustand eintreten, ein Übergang vom zweiten Schritt (S303) zum dritten Schritt (S306) durchgeführt wird.

7. Abschaltsteuerverfahren nach Anspruch 1, wobei in dem zweiten Schritt (S303), wenn eine vorbestimmte Zeitspanne in einem Zustand verstreicht, in dem ein Übergang von einem Zustand, in dem sich beide der beiden Signale in dem vorbestimmten PWM-Abschaltzustand befinden, zu einem Zustand, in dem sich eines der zwei Signale in dem vorbestimmten Abschaltaufhebungszustand befindet, durchgeführt wird, bestimmt wird, dass es sich um einen vorbestimmten abnormen Zustand handelt, und eine Warninformationen an die Vorrichtung ausgegeben wird.

8. Abschaltsteuerverfahren nach Anspruch 7, wobei in dem zweiten Schritt (S303) mehrere vorbestimmte Zeitperioden eingestellt werden und mehrere Warnsignale jedes Mal, wenn die verstrichene Zeit zunimmt, an die Vorrichtung ausgegeben werden.

9. Abschaltsteuerverfahren nach Anspruch 7, wobei in dem zweiten Schritt (S303) die Fortsetzung des Abschaltzustand veranlasst wird, wenn ein Vorgang, bei dem beide der beiden Signale veranlasst werden, in einen vorbestimmten Abschaltaufhebungszustand einzutreten, nachdem beide der beiden Signale veranlasst wurden, in den vorbestimmten PWM-Abschaltzustand einzutreten, der der zweite Schritt (S303) ist, nicht erneut ausgeführt wird, wenn eine vorbestimmte Zeit verstrichen ist.

10. Elektrische Leistungswandlungsvorrichtung (100), umfassend:
eine DC-Wandlungseinheit (102), die dazu ausgelegt ist, eine Wechselspannung (AC) einer AC-Spannungsquelle in eine Gleichspannung (DC) umzuwandeln;
eine DC-Glättungseinheit (103), die zur Glättung der DC-Spannung ausgelegt ist;
eine PWM-Erzeugungseinheit (131), die zur Erzeugung eines PWM-Signals ausgelegt ist;
eine AC-Wandlungseinheit (104), die dazu ausgelegt ist, die geglättete DC-Spannung unter Verwendung des PWM-Signals in eine AC-Spannung umzuwandeln und die AC-Spannung auszugeben;
eine erste und eine zweite Signaleingabeeinheit (111, 112), von denen jede für den Empfang eines Abschaltbefehlssignals von außerhalb ausgelegt ist;
eine erste und eine zweite PWM-Abschalteinheit (121, 122), von denen jede dazu ausgelegt ist, das von der PWM-Erzeugungseinheit (131) auszugebende PWM-Signal an die AC-Wandlungseinheit (104) in jeweiligen Systemen weiterzuleiten oder abzuschalten; und
eine Diagnoseeinheit (132), die dazu ausgelegt ist, Zustände von zwei Abschaltbefehlssignalen von der ersten und der zweiten Signaleingabeeinheit (111, 112) zu diagnostizieren und einen Abschaltbefehl an die erste und die zweite PWM-Abschalteinheit (121, 122) auszugeben,
wobei, wenn die beiden Abschaltbefehlssignale einem vorbestimmten PWM-Abschaltzustand entsprechen, die Diagnoseeinheit (132) dazu ausgelegt ist, ein Abschaltsignal an die erste und die zweite PWM-Abschalteinheit (121, 122) auszugeben, um zu bewirken, dass beide der beiden Abschaltbefehlssignale in den vorbestimmten Abschaltaufhebungszustand eintreten, nachdem beide Zustände der beiden Abschaltbefehlssignale in den vorbestimmten PWM-Abschaltzustand eintreten, den Abschaltzustand der ersten und zweiten PWM-Abschalteinheit (121, 122) aufzuheben und die erste und die zweite PWM-Abschalteinheit (121, 122) zu aktivieren, ohne einen Rücksetzvorgang durchzuführen, und
wobei, wenn die beiden Abschaltbefehlssignale von dem vorbestimmten PWM-Abschaltzustand in den vorbestimmten Abschaltaufhebungszustand übergehen, die Diagnoseeinheit (132) dazu ausgelegt ist, die Aktivierung der Vorrichtung unter Verwendung eines Signals aus den beiden Signalen, das später in den vorbestimmten Abschaltaufhebungszustand eintritt, als Trigger zu ermöglichen.

## Revendications

1. Procédé de commande d'arrêt pour décider d'un état d'arrêt d'un dispositif de conversion d'énergie électrique (100) qui comprend un convertisseur CC/CA (104) recevant une commande PWM d'une unité de génération PWM (131) conformément aux états de transition de deux signaux reçus d'un extérieur, comprenant :
une première étape (S301) de sortie de deux commandes d'arrêt PWM vers des unités d'arrêt PWM (121, 122) à l'intérieur du dispositif de conversion d'énergie électrique (100) lorsque les deux signaux correspondent à un état d'arrêt PWM prédéterminé ;
une deuxième étape (S303) pour amener les deux signaux à entrer dans un état d'annulation d'arrêt prédéterminé après que les deux signaux soient entrés dans l'état d'arrêt PWM prédéterminé ; et
une troisième étape (S306) d'annulation de l'état d'arrêt du dispositif de conversion d'énergie électrique (100) et d'activation du dispositif de conversion d'énergie électrique (100) sans effectuer de processus de réinitialisation,
**caractérisé en ce que**, à la troisième étape (S306), lorsque les deux signaux passent de l'état d'arrêt PWM prédéterminé à l'état d'annulation d'arrêt prédéterminé, l'activation du dispositif de conversion d'énergie électrique (100) est autorisée en utilisant comme déclencheur un signal parmi les deux signaux qui entre plus tard dans l'état d'annulation d'arrêt prédéterminé.

2. Procédé de commande d'arrêt selon la revendication 1, dans lequel, à la première étape (S301), lorsqu'une période de temps prédéterminée ou plus s'écoule dans un état dans lequel un seul des deux signaux est dans l'état d'arrêt PWM prédéterminé, et l'autre est dans l'état d'annulation d'arrêt prédéterminé, il est déterminé qu'il s'agit d'un état anormal prédéterminé, et une information d'avertissement est délivrée au dispositif.

3. Procédé de commande d'arrêt selon la revendication 2, dans lequel, à la première étape (S301), une pluralité de périodes de temps prédéterminées sont définies, et une pluralité de signaux d'avertissement sont délivrés au dispositif en fonction du temps écoulé à chaque fois que le temps écoulé augmente.

4. Procédé de commande d'arrêt selon la revendication 1, dans lequel, à la première étape (S301), lorsqu'une transition d'un état dans lequel l'un des deux signaux est dans l'état d'arrêt PWM prédéterminé, et l'autre est dans l'état d'annulation d'arrêt prédéterminé vers un état dans lequel les deux signaux sont dans l'état d'annulation d'arrêt prédéterminé est effectuée, il est déterminé qu'il s'agit d'un état anormal prédéterminé, et une information d'avertissement est délivrée au dispositif.

5. Procédé de commande d'arrêt selon la revendication 1, dans lequel une information d'avertissement est délivrée au dispositif lorsque les deux signaux sont dans les états d'arrêt PWM prédéterminés pendant que la transition de la première étape (S01) à la deuxième étape (S303) est en cours.

6. Procédé de commande d'arrêt selon la revendication 1, dans lequel, lorsque les deux signaux sont dans l'état d'arrêt PWM prédéterminé et entrent dans l'état d'annulation d'arrêt prédéterminé dans une période de temps prédéterminée, une transition de la deuxième étape (S303) à la une troisième étape (S306) est effectuée.

7. Procédé de commande d'arrêt selon la revendication 1, dans lequel, à la deuxième étape (S303), lorsqu'une période de temps prédéterminée s'est écoulée dans un état dans lequel une transition d'un état dans lequel les deux signaux sont dans l'état d'arrêt PWM prédéterminé vers un état dans lequel l'un quelconque des deux signaux est dans l'état d'annulation d'arrêt prédéterminé est effectuée, il est déterminé qu'il s'agit d'un état anormal prédéterminé, et une information d'avertissement est délivrée au dispositif.

8. Procédé de commande d'arrêt selon la revendication 7, dans lequel, à la deuxième étape (S303), une pluralité de périodes de temps prédéterminées sont définies, et une pluralité de signaux d'avertissement sont délivrés au dispositif chaque fois que le temps écoulé augmente.

9. Procédé de commande d'arrêt selon la revendication 7, dans lequel, à la deuxième étape (S303), l'état d'arrêt est amené à se poursuivre si une opération consistant à amener les deux signaux à entrer dans un état d'annulation d'arrêt prédéterminé après avoir amené les deux signaux à entrer dans l'état d'arrêt PWM prédéterminé qui est la deuxième étape (S303) n'est pas réalisée à nouveau lorsqu'un temps prédéterminé s'est écoulé.

10. Dispositif de conversion d'énergie électrique (100), comprenant :
une unité de conversion CC (102) qui est conçue pour convertir une tension de courant alternatif (CA) d'une source d'alimentation CA en une tension de courant continu (CC) ;
une unité de lissage CC (103) qui est conçue pour lisser la tension continue ;
une unité de génération PWM (131) qui est conçue pour générer un signal PWM ;
une unité de conversion CA (104) qui est conçue pour convertir la tension continue lissée en une tension alternative en utilisant le signal PWM et délivrer la tension alternative ;
des première et seconde unités d'entrée de signal (111, 112) qui sont chacune conçues pour recevoir un signal de commande d'arrêt depuis un extérieur ;
des première et seconde unités d'arrêt PWM (121, 122) qui sont chacune conçues pour faire passer ou couper le signal PWM à émettre de l'unité de génération PWM (131) vers l'unité de conversion CA (104) dans des systèmes respectifs ; et
une unité de diagnostic (132) qui est conçue pour diagnostiquer les états de deux signaux de commande d'arrêt des première et seconde unités d'entrée de signal (111, 112) et délivrer une commande d'arrêt aux première et seconde unités d'arrêt PWM (121, 122),
dans lequel, lorsque les deux signaux de commande d'arrêt correspondent à un état d'arrêt PWM prédéterminé, l'unité de diagnostic (132) est conçue pour émettre un signal d'arrêt vers les première et seconde unités d'arrêt PWM (121, 122), amener les deux signaux de commande d'arrêt à entrer dans l'état d'annulation d'arrêt prédéterminé après que les deux états des deux signaux de commande d'arrêt entrent dans l'état d'arrêt PWM prédéterminé, annuler l'état d'arrêt des première et seconde unités d'arrêt PWM (121, 122), et activer les première et seconde unités d'arrêt PWM (121, 122) sans effectuer de processus de réinitialisation, et
dans lequel, lorsque les deux signaux de commande d'arrêt passent de l'état d'arrêt PWM prédéterminé à l'état d'annulation d'arrêt prédéterminé, l'unité de diagnostic (132) est conçue pour permettre l'activation du dispositif en utilisant comme déclencheur un signal parmi les deux signaux qui entre plus tard dans l'état d'annulation d'arrêt prédéterminé.
